# EUROPÄISCHE PATENTSCHRIFT

(11) **EP 2 623 829 B1**
(45) Veröffentlichungstag und Bekanntmachung des Hinweises auf die Patenterteilung: **14.11.2018**
(21) Anmeldenummer: 13000266.0
(22) Anmeldetag: 18.01.2013
(51) Int. Cl.: F16K 37/00, G05B 19/042, G05B 19/406, F16K 31/02, H01L 35/02, H01L 35/28

(54) **Stellventil zum Einstellen einer Prozessfluidströmung in einer prozesstechnischen Anlage**
Control valve for adjusting a process fluid flow in a technical process plant
Vanne de régulation permettant de régler un flux de fluide de procédé dans une installation technique de processus

(30) Priorität: 06.02.2012 DE 102012002316
(43) Veröffentlichungstag der Anmeldung: 07.08.2013
(73) Patentinhaber: Samson Aktiengesellschaft, 60314 Frankfurt (DE)
(72) Erfinder: Kiesbauer, Jörg, 64859 Eppertshausen (DE)
(74) Vertreter: Schmid, Nils T.F.

(56) Entgegenhaltungen:
- WO-A1-2012/004471
- DE-A1-102006 011 503
- DE-A1-102010 029 090
- GB-A- 2 140 206

## Beschreibung

Die Erfindung betrifft ein Stellventil zum Einstellen einer Prozessmediumströmung einer prozesstechnischen Anlage, wie eine Raffinerie, eine Lebensmittelanlage, wie eine Brauerei, oder eine petrochemische Anlage, oder dergleichen.

Prozesstechnische Anlagen sollen weitestgehend automatisiert arbeiten, weswegen Prozessparameter der Prozessmediumströmung, wie die Stellung des Stellventils einer prozesstechnischen Anlage, sehr wichtige Regelungsgrößen sind. Diese Parameter werden üblicherweise einer Leitwarte oder einem das Stellventil steuernden Stellungsregler kommuniziert. Für viele der eingesetzten Stellventile steht allerdings nicht ohne weiteres eine elektrische Infrastruktur zur Verfügung, um elektrische Informationssignale zu generieren, weiterzuleiten und/oder zu verarbeiten. Es ist bekannt, beispielsweise eine kabellose Kommunikation über Funk einzusetzen. Dort, wo eine Zugänglichkeit zur einfachen Montage von Signalleitungen möglich ist oder wo ein hoher Sicherheitsstandard hinsichtlich der Übertragung von Signalen erforderlich ist, ist die klassische Signalüberleitung mittels Drähte vorzuziehen.

Grundsätzlich besteht bei allen Prozessen der Signalerzeugung und -kommunikation das Problem, dass möglichst eine batterielose, zündsicher elektrische Energieversorgung zur Verfügung steht. Es gibt Bestrebungen vor allem bei pneumatisch betriebenen Stellventilen beispielsweise kleine Turbinen in der das Stellventil stellenden pneumatischen Betätigungsaktuation einzubauen, welche die pneumatische Energie in elektrische Energie umwandeln. Bei solchen mit Druckluft betriebenen Kleinturbinen besteht allerdings das grundsätzliche Problem, dass bei Ausfall der Druckluft eine kontinuierliche Energieversorgung ohne zusätzlichen Batterieeinsatz nicht möglich ist. Auch der Einsatz von Kleinturbinen innerhalb der Prozessmediumströmung ist insofern nicht unkritisch, als im Prozessfluid für Miniturbinen kritische Umgebungsbedingungen herrschen insbesondere dann, wenn das Prozessfluid mit Partikeln versetzt ist. Weiterhin existieren für derartige Systeme kaum Langzeitstudien, welche ein zuverlässiges Energieversorgen belegen könnten.

WO 2012/004471 A1 betrifft eine Fluidverteilungsvorrichtung mit einem Druckminderer.

Aus DE 10 2006 011 503 A1 ist ein eine kontinuierliche Energieversorgung mittels Energiewandler für elektropneumatisch betriebener Stellungsregler zum Einsatz in einer prozesstechnischen Anlage bekannt. Aus der Druckdifferenz zwischen Umgebungsluft und dem Druck der Versorgungsdruckluft, welche ein Stellventil betätigen soll, soll mittels eines piezoelektrischen Elements, eines thermoelektrischen Elements oder einer mechanischen Turbine elektrische Versorgungsenergie aus der Druckluftversorgung bereitgestellt werden.

Bei dieser Technik hängt die damit erreichte autark kontinuierliche Energieversorgung davon ab, dass Druckluft auch stets als Energieversorgung vorliegt. In prozesstechnischen Anlagen gibt es allerdings häufig Fälle, dass die Druckluftversorgung ausfällt, wodurch eine elektrische Energieversorgung beispielsweise zur Bestimmung der Stellventilposition nicht mehr kontinuierlich erfolgen kann. Des Weiteren zeigt sich, dass häufig auch Druckluftschwankungen einen komplizierten elektrischen Regelungsaufwand zur Energieversorgung notwendig machen. Weiterhin können Stellgeräte auch durch elektromotorische Antriebskräfte betätigt werden.

Es ist Aufgabe der Erfindung, die Nachteile des Stands der Technik zu überwinden, insbesondere ein Stellventil zum Einstellen einer Prozessmediumströmung einer prozesstechnischen Anlage dahingehend zu verbessern, dass Strömungsparameter des Prozessmediums über einen langen Zeitraum kontinuierlich und höchst zuverlässig bereit gestellt werden können, ohne insbesondere einen hohen Montageaufwand für die autarke Energieversorgung hinnehmen zu müssen.

Diese Aufgabe wird durch die Merkmale von Anspruch 1 gelöst.

Danach ist ein Stellventil zum Einstellen einer Prozessmediumströmung einer prozesstechnischen Anlage vorgesehen, das ein Gehäuse mit einem von dem Prozessmedium zu durchströmenden Innenraum aufweist. Das Gehäuse kann beispielsweise aus einem stromabwärtigen Leitungsanschlussteil, einem stromaufwärtigen Leitungsanschlussteil, einer die Leitungsanschlussteile voneinander trennende Blendenwand, welche einen den Ventildurchgang begrenzenden Ventilsitz bilden oder aufnehmen kann, und einer stellventilantriebsseitigen, häufig das Gehäuse dicht verschließenden Buchse bestehen, durch welche hindurch eine Stellstange oder eine Stellwelle ragt. Der Ventilsitz stellt zwischen dem stromaufwärtigen Leitungsanschluss und dem stromabwärtigen Leitungsanschluss des Gehäuses eine Drosselstelle mit definierter Geometrie dar. An dem stromaufwärtigen Leitungsanschluss sowie an dem stromabwärtigen Leistungsanschluss sind Flanschbereiche vorsehbar, an denen weiterführende Leitungsrohre der prozesstechnischen Anlage angeschlossen werden sollen. Des Weiteren hat das erfindungsgemäße Stellventil ein den Ventilsitz belegendes oder freigebendes Ventilglied oder Verschlussteil, insbesondere einen Ventilkegel. Das Ventilglied dient dazu, den insbesondere engsten Durchgangsquerschnitt an der Blende zwischen dem Ventilglied und dem Ventilsitz zu verändern, insbesondere zu öffnen oder zu schließen, um die Prozessmediumströmung beispielsweise gemäß einer Regelungsroutine einzustellen, insbesondere einen Druckabfall zwischen den in dem stromaufwärtigen Leitungsabschnitt des Stellventils herrschenden Druck und dem in der stromabwärtigen Leitungsabschnitt herrschenden Druck einstellen zu können.

Des Weiteren hat das erfindungsgemäße Stellventil einen elektrischen Verbraucher, wie einen Sensor, insbesondere einen Positionssensor, einen Stellungsregler, insbesondere einen Mikrochip, einen elektrischen Speicher, einen Sender, einen Akkumulator oder dergleichen. Es sei klar, dass der elektrischer Verbraucher auch dann als ein solcher zu verstehen ist, wenn das Stellventil zumindest einen elektrischen Anschluss aufweist, an den ein oben genannter Verbraucher angeschlossen werden kann.

Das erfindungsgemäße Stellventil hat zusätzlich ein thermoelektrisches Element in dem Gehäuseinnenraum, das zur Versorgung mit elektrischer Energie an den elektrischen Verbraucher gekoppelt ist. Auf diese Weise kann ausgehend vom Ort der Anordnung des thermoelektrischen Elements, also in unmittelbarer Nähe zum Ventilglied und/oder zum Ventilsitz im Gehäuseinnenraum, wegen einer bei Druckabfall einhergehenden Temperaturdifferenz der Prozessmediumströmung elektrische Energie zur Weiterleitung an den Verbraucher erzeugt werden. Es zeigte sich in Versuchen mit thermoelektrischen Elementen im fluidischen Kontakt mit der Prozessmediumsströmung, dass eine konstante, dauerhafte und zuverlässige Energieversorgung bereitgestellt wird. Dies ist auch dann gültig, wenn innerhalb der Prozessmediumströmung Feststoffpartikel mitgeführt werden, welche bei anderen Energiewandlern, wie Turbinen, einen hohen Verschleiß verursachen. Erfindungsgemäß ist es möglich, regelungsfunktionssichere Stellventile bereitzustellen, die über eine autarke Energieversorgung verfügen. Da bei den meisten Stellventilanlagen zu erwarten ist, dass eine Prozessmediumströmung selbst bei einem Energieversorgungstotalausfall zumindest für einen bestimmten Zeitraum bestehen bleibt, ist mit dem thermoelektrischen Element im Innenraum des Stellventils eine stets bereitstehende Energieversorgung verfügbar.

Um den höchsten Energieertrag durch das thermoelektrische Element zu erreichen, ist vorzugweise das thermoelektrische Element im sogenannten Bereich "Vena Contracta" anzuordnen, also längs des Strömungsverlaufs durch das Stellventilgehäuse hindurch im kleinsten Durchtrittsquerschnitt, insbesondere in der Mitte des verengten Strömungskanals.

Im Hinblick auf eine optimale Anordnung des thermoelektrischen Elements wurde auch von den Erfindern beobachtet, dass in der Prozessmediumströmung eine deutliche Temperaturabsenkung in der Nachbarschaft von Metallteilen auftritt. Auf diese Weise ist bei der Anbringung des thermoelektrischen Elements eine einfache und feste Montage gewährleistet. Als Anbringungsort des thermoelektrischen Elements können vor allem der Ventilkegel oder das Ventilglied oder der Ventilsitz in Frage kommen. Es konnten sehr gute Energieerzeugungsergebnisse erreicht werden, wenn eine hohe Wärmeleitfähigkeit am Ort der Montage des thermoelektrischen Elements genutzt wird. Insofern kann es von Vorteil sein, das Material der Montagestelle für das thermoelektrische Element mit einem besonders hohen Wärmeleitfähigkeitskoeffizienten zu versehen.

Bei dem Einsatz des thermoelektrischen Elements ist ein Referenzpunkt erforderlich, dessen Anbringungsort insbesondere im eintrittsseitigen Strömungsbereich des Stellventils beispielsweise entweder innerhalb des Strömungskanals oder an einer entsprechenden Wandung von Vorteil ist.

Bei einer bevorzugten Ausführung der Erfindung sind in ein- und demselben Stellventilgehäuse mehrere thermoelektrische Elemente angeordnet, die für eine erhöhte Energieausbeute sorgen können. Dabei können die thermoelektrischen Elemente miteinander in Reihe geschaltet sein. Es könnte beispielsweise angedacht sein, auch ein weiteres thermoelektrisches Element in den Betätigungsluftdruckkreislauf anzuordnen, der für das Stellen des Stellventils verantwortlich ist.

Bei einer bevorzugten Ausführung der Erfindung ist das thermoelektrische Element in dem Bereich eines insbesondere minimalen Strömungsdurchgangs zwischen dem Ventilglied und dem Ventilsitz positioniert. Mit einer je nach Stellung des Ventilglieds wandernden Stelle des minimalsten Strömungsdurchgangsquerschnitts kann ein insbesondere flächiges und/oder folienartiges thermoelektrisches Element vorgesehen werden, um sicherzustellen, dass in jeder Ventilglied-Stellung das thermoelektrische Element in dem Bereich des minimalsten Strömungsdurchgangsquerschnitts liegt.

Ein thermoelektrisches Element kann auch innerhalb der Prozessmediumströmung im Durchgang zwischen dem Ventilglied und dem Ventilsitz also in einem Abstand davon angeordnet sein. Am engsten Durchströmungsquerschnitt ist mit dem höchsten Druckabfall und mit den höchsten Temperaturgradienten zu rechnen.

Erfindungsgemäß ist das thermoelektrische Element an einer Außenseite des Ventilglieds, und/oder an einer Innenseite des Ventilsitzes angeordnet. Der Ventilsitz kann als separat montierbares Bauteil, wie eine Steckhülse, ausgeführt sein, das mit einem Gehäuseinnenteil befestigt, insbesondre verschraubt, ist oder als ein einstückiges Bauteil mit dem Gehäuseinnenteil ausgeführt sein. Der Ventilsitz hat eine umlaufende Dichtfläche, die mit einer entsprechenden umlaufenden Dichtfläche des Ventilglieds dichtend und den Durchgang des Stellventils abschließend zusammenwirken kann. Es kann vorgesehen sein, dass ein thermoelektrisches Element an der Stelle der Ventilfläche des Ventilglieds und/oder des Ventilsitzes angeordnet ist.

Vorzugsweise liegt das thermoelektrische Element an einer Profilierung, wie einer Stufe, eines Absatzes, eines Hinterschnitts, des Ventilsitzes und/oder des Ventilglieds. Es zeigte sich, dass sich bei solchen Profilierungen bei einer allmählichen Zunahme des Druckabfalls des Prozessmediums zuerst eine überkritische Strömung einstellt, wo sich die größten Temperaturgradienten bilden.

Bei einer Weiterbildung der Erfindung ist das thermoelektrische Element innerhalb eines Strömungsdurchgangs zwischen dem Ventilglied und dem Ventilsitz in einem Abstand davon angeordnet, wobei die Anordnungsstelle des thermoelektrischen Elements strömungsabwärts des Ventilsitzes und/oder des Ventilglieds positioniert ist.

Bei einer bevorzugten Ausführung der Erfindung hat das Gehäuse einen stromabwärtigen Leitungsanschluss und einen stromaufwärtigen Leitungsanschluss. Das thermoelektrische Element kann im Inneren des stromabwärtigen Leitungsanschlusses insbesondere in einem Abstand von einer Leitungswand und/oder an einer Innenfläche der Leitungswand positioniert sein. Insbesondere die Leitungswand ist heranzuziehen, auf die die Prozessmediumströmung nach Verlassen des Ventilsitzes zuerst trifft und/oder den geringsten Abstand davon aufweist.

Das thermoelektrische Element kann insbesondere in einem Bereich von oder auf einer dem Ventilsitz zugewandten Außenfläche des Ventilglieds positioniert sein. Diese Außenfläche kann auf einer dem stromabwärtigen Leitungsabschnitt zugewandten Seitenhälfte des Ventilglieds liegen. Insbesondere im Falle eines rotationsförmigen, insbesondere zylindrischen und/oder kegelförmigen, Ventilglieds liegt das thermoelektrische Element auf einer dem stromabwärtigen Leitungsabschnitt am nächsten liegenden vorzugsweise auf einer in Stellrichtung des Ventilglieds gerichteten Tangentiallinie an der Außenfläche des Ventilglieds.

Bei einer bevorzugten Ausführung der Erfindung ist das thermoelektrische Element an einer dem Ventilglied zugewandten Innenseite des Ventilsitzes positioniert, die auf einer dem stromabwärtigen Leitungsabschnitt nahe liegenden Seitenhälfte liegt. Im Falle eines kreisringförmigen Ventilsitzes ist der Bereich der Anordnung des thermoelektrischen Elements derart gewählt, dass er dem stromaufwärtigen Leitungsabschnitt zugewandt ist.

Ein thermoelektrisches Element hat als Grundaufbau einen Metall-Metall-Kontakt, wobei aufgrund einer Temperaturdifferenz zu einer Vergleichsstelle elektrische Energieflüsse erzeugt werden können. Zur Erhöhung der elektrischen Energieausbeute werden die thermoelektrischen Elemente vorzugsweise in einer hohen Anzahl in Reihe geschaltet.

Bei einer bevorzugten Ausführung der Erfindung bildet das thermoelektrische Element, insbesondere die thermoelektrische Reihenschaltung, eine dünne Platten- oder Folienstruktur. Auf diese Weise kann ein großes Verhältnis zwischen Energieresultat und notwendigem Raumbedarf erreicht werden. Die Platten- oder Folienstruktur kann derart angeordnet und bemessen sein, dass sich zumindest ein Teil davon in einem Bereich des größten Druckabfalls der Prozessmediumsströmung längs des Strömungsverlaufs erstreckt.

Die Platten- oder Folienstruktur des thermoelektrischen Elements kann eine Silikon-Wafer-Struktur sein. Dabei ist die erste Lage, der Wafer, ventilsitzseitig und/oder ventilgliedseitig angeordnet, wobei der Wafer an der jeweiligen Außenfläche befestigt, insbesondere geklebt, ist. Die über dem Wafer liegende Silikonschicht ist prozessmediumsströmungsseitig positioniert. Zwischen dem Waver und der Silikonschicht kann eine Vielzahl von thermoelektrischen Verbundstoffpaaren in einer Sandwichanordnung eingebracht sein.

Des Weiteren betrifft die Erfindung ein Verfahren zum Bereitstellen elektrischer Energie für einen elektrischen Verbraucher, wie einen I/P-Wandler, einen Stellungsregler, einen Sensor, wie einen Positionssensor, einer Funkübertragung oder dergleichen. Insbesondere kann die elektrische Energiebereitstellung für den elektrischen Verbraucher eines Stellventils vorgesehen sein. Das Leitungssystem der prozesstechnischen Anlage wird oder ist mit einer Querschnittsverengung versehen, die beispielsweise durch eine fest montierte Blende zur Durchflussmessung oder einer Drosselstelle des insbesondere erfindungsgemäßen Stellventils ausgebildet ist. Erfindungsgemäß ist im Bereich der Querschnittsverengung, beispielsweise unmittelbar stromabwärts von dieser, ein thermoelektrisches Element innerhalb der Prozessmediumströmung angeordnet, das zur Versorgung elektrischer Energie mit dem elektrischen Verbraucher gekoppelt wird und am Ort der Anordnung des thermoelektrischen Elements mittels einer mit dem Druckabfall einhergehenden Temperaturdifferenz elektrische Energie zur Weiterleitung an den elektrischen Verbraucher durch das thermoelektrische Element erzeugt wird.

Im Falle der Anordnung des elektrothermischen Element innerhalb eines Gehäuses eines Stellventils hat letzteres einen Ventilsitz und ein den Ventilsitz schließendes oder freigebendes Ventilglied. Ein Strömungsquerschnitt des Stellventils ist je nach relativer Position zwischen dem Ventilglied und dem Ventilsitz zum Einstellen der Prozessmediumströmung veränderbar. Auf diese Weise kann eine Druckänderung in der Prozessmediumströmung insbesondere zwischen dem stromabwärtigen und dem stromaufwärtigen Leitungsabschnitt veranlasst werden. Der elektrische Verbraucher soll von der bereitgestellten Energie versorgt werden. In dem Gehäuseinneren wird ein von dem Prozessmedium zu umströmendes thermoelektrisches Element angeordnet. Das thermoelektrische Element wird mit dem elektrischen Verbraucher gekoppelt. Am Ort der Anordnung des thermoelektrischen Elements wird mittels eines bei Druckänderung in der Prozessmediumströmung einhergehenden Temperaturgradienten elektrische Energie zur Weiterleitung an den Verbraucher durch das thermoelektrische Element erzeugt.

Weitere Verfahrensaspekte sind entsprechend der Funktionsweise des erfindungsgemäßen Stellventils definiert.

Weitere bevorzugte Ausgestaltungen sind in den Unteransprüchen angegeben.

Weitere Eigenschaften, Vorteile und Merkmale der Erfindung sind in der folgenden Beschreibung bevorzugter Ausführungen der Erfindung anhand der beiliegenden Zeichnungen erkennbar, in denen zeigen:
- Figur 1: eine technische Prinzipskizze eines erfindungsgemäßen, an eine Anlagenleitung der prozesstechnischen Anlage angeschlossenes Stellventil, wobei im Verlauf der Strömung durch das Stellventil die Druckverhältnisse mittels eines unter der Prinzipskizze gezeigten Linienverlaufs angedeutet sind;
- Figur 2: eine Querschnittsansicht eines in einer prozesstechnischen Anlage montierten Stellventils, wobei innerhalb der Leitungen und am Stellventil Druckverhältnisse des Prozessfluids graphisch dargestellt sind; und
- Figur 3: eine Graphik, bei der eine Temperaturmessung an einem Stellventil im Verlauf der Zeit bei unterschiedlichen Differenzdrücken zwischen einer stromaufwärtigen und stromabwärtigen Stelle am erfindungsgemäßen Stellventil angezeigt sind.

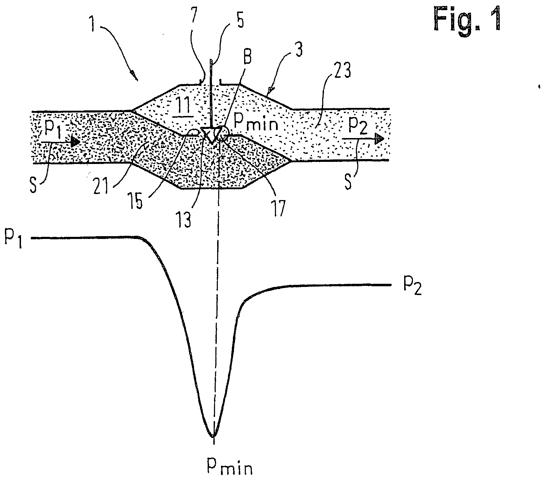

In Figur 1 ist ein erfindungsgemäßes Stellventil 1 schematisch dahingehend dargestellt, dass es ein Gehäuse 3 umfasst. Das Stellventil 1 wird von einem nicht näher dargestellten pneumatischen Stellantrieb betätigt, dessen Stellstange 5 durch eine in dem Gehäuse 3 ausgebildete Öffnung 7 in das Innere 11 des Gehäuses 3 gelangt und in einem insbesondere kegelförmigen Ventilglied 13 mündet. Der pneumatische Stellantrieb wird von einem Stellungsregler (nicht dargestellt) gesteuert, der das Ventilglied 13 auf und ab bewegt, um die Prozessmediumströmung S einzustellen.

Im Inneren des Gehäuses 3 des Stellventils 1 ist ein Ventilsitz 15 vorgesehen, der zum Schließen eines Ventildurchgangs 17 mit dem Ventilglied 13 kooperiert.

Der Ventilsitz 15 trennt strukturell einen stromaufwärtigen Leitungsabschnitt 21 von einem stromabwärtigen Leitungsabschnitt 23 des Gehäuses 3 des Stellventils 1. Auf diese Weise generiert, je nach Stellung des Ventilglieds 13, das Stellventil 1 einen Druckabfall zwischen dem in dem stromaufwärtigen Leitungsabschnitt 21 herrschenden Strömungsdruck p₁ und dem in dem stromabwärtigen Leitungsabschnitt wirkenden Strömungsdruck p₂. Der größte Druckabfall ist in dem Kreis B zu erwarten, wobei der Druckverlauf des Strömungsdrucks P qualitativ unterhalb der schematischen Skizze in Figur 1 durch den Graphverlauf angedeutet ist.

Der minimale Druck pₘᵢₙ herrscht in dem Bereich des minimalen Durchgangsquerschnitts zwischen dem Ventilsitz 15 und dem Ventilglied 13, und zwar in dem insbesondere gegenüber den Ventilgliedseiten stromabwärtigen Durchgangsbereich, der mit der begrenzten Kreislinie B in Figur 1 angedeutet ist.

Es ist festzustellen, dass insbesondere an dem engsten Durchgangsquerschnitt zwischen dem Ventilsitz 15 und dem Ventilglied 13 eine überkritische Strömung auftreten kann. Es zeigte sich, dass dieser überkritische Strömungszustand dann auftritt, wenn ein Druckverhältnis von p₂ zu p₁ etwa 0,50 bis 0,56 unterschritten wird, was von einem gasförmigen Prozessmediumstyp abhängt.

Bei dem erfindungsgemäßen Stellventil 1 ist im Bereich der zu erwartenden größten Mediumgeschwindigkeit, die mit dem geringsten Druck korrespondiert (größte Druckabsenkung) ein sogenanntes thermoelektrisches Element vorzusehen, das eine Temperaturdifferenz zur Erzeugung elektrischer Energie ausnützt.

Es zeigt sich, dass im stromabwärtigen Durchgangsbereich zwischen dem Stellglied 13 und dem Ventilsitz 15 der größte Temperaturgradient bei Auftreten überkritischer Strömungen erreicht wird, wodurch eine ausreichend große Energieversorgung beispielsweise zur Betreibung eines Positionssensors oder anderer elektronischer Komponenten zur Verfügung gestellt wird. Es sei klar, dass das thermoelektrische Element auch an einer anderen Stellen innerhalb des Stellventilgehäuses anzuordnen ist, wo ein ausreichender Druckabfall und somit ein ausreichender Temperaturgradient entsteht, indem beispielsweise eingebaute Blenden oder andere Querschnittsverengungen genutzt werden. Besonders vorteilhaft sind Querschnittsverengungen, bei denen eine überkritische Strömung zu erwarten ist.

Bei einer Versuchsanordnung mit einer Blende (Blendendurchmesser von 5 mm, Umgebungstemperatur von 23°C, Temperatur des Prozessmediums von 26,5°C im stromaufwärtigen Bereich) ist festgestellt, dass auch bei unterschiedlichen Druckabfällen von 1,5 bar bis 4 bar stets eine im wesentlichen ähnliche Druckabfallcharakteristik im Bereich der Blende erreicht werden kann. Auf diese Weise kann mit dem thermoelektrischen Element sichergestellt werden, dass auch bei unterschiedlichen Bedingungen des Betriebs der prozesstechnischen Anlage, insbesondere der Prozessmediumsströmung, stets eine kontinuierliche und gleichbleibende Energieversorgung bereitgestellt wird. Eine komplizierte Elektronikvorschaltung zur Gleichrichtung der elektrischen Energieversorgung mit einem hohen Bauteilaufwand ist nicht notwendig. Es zeigte sich, dass ein thermoelektrisches Element innerhalb der Prozessmediumströmung sehr gut dazu geeignet ist, Energie für elektronische Komponenten der unmittelbaren Umgebung des Stellventils, wie einen Positionssensor, einen Signalsender, einen Stellungsregler, einen Stromdruckwandler, etc., zu erzeugen.

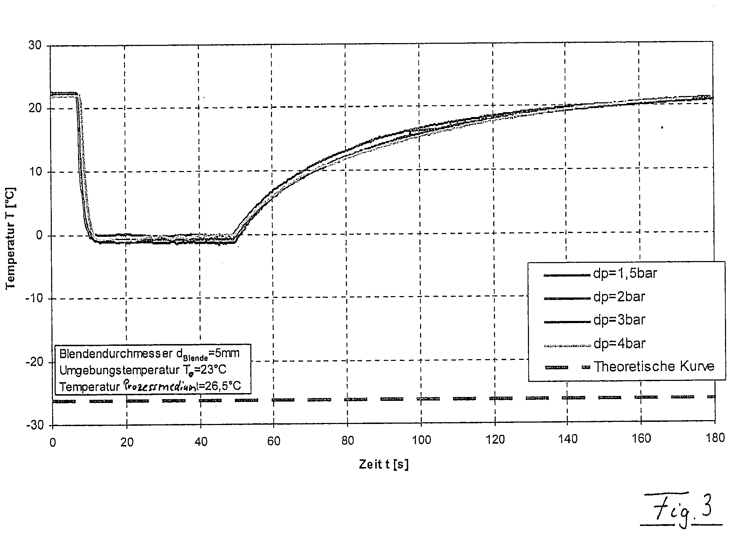

In Figur 3 ist eine Graphik dargestellt, welche die gemessene Temperatur an einer Blende für unterschiedliche Druckabfälle innerhalb des Prozessmediums von 1,5 bar bis 4 bar darstellt. Wie aus der Graphik ersichtlich ist, ist ein relativ abweichungsfreier Temperaturverlauf selbst bei niedrigen Prozessmediumsströmungsdrücken erreichbar, wodurch eine zuverlässige und vorhersehbare Energiebereitstellung durch das thermoelektrische Element sichergestellt ist. Folglich kann selbst bei der starken Variation der Prozessmediumströmung eine gleichbleibende Energieerzeugung für den elektrischen Verbraucher erreicht werden. Die in Figur 3 dargestellte, geradlinige strichlierte (theoretische) Linie bei etwa -26°C gibt den theoretischen Verlauf der Temperatur über der Zeit an, welche Temperatur sich bei mathematischer Näherung entsprechend adiabatisch isentroper Entspannung bezogen auf die Eingangstemperatur einstellen müsste.

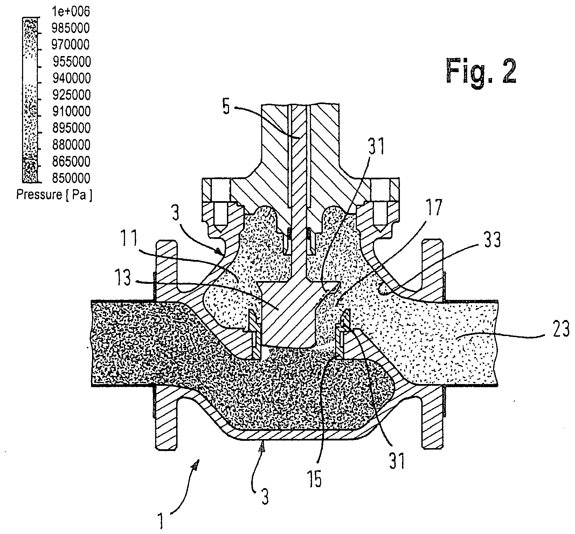

Figur 2 zeigt eine Querschnittsansicht eines erfindungsgemäßen Stellventils gemäß der Prinzipskizze nach Figur 1.

Innerhalb des Stellventils ist mittels graphischer Darstellung der herrschende Druck angedeutet, wobei erkennbar ist, dass in dem gegenüber dem Ventilsitz 15 stromaufwärtigen Leitungsabschnitt 21 sehr hohe Drücke herrschen, während in dem stromabwärtigen Leitungsabschnitt 23 ein niedriger Druck besteht. Der Ventilsitz 15 ist an einem Gehäuseinnenteil des Stellventils 1 als separates Bauteil eingesetzt, insbesondere daran verschraubt.

Unmittelbar am Ventilsitz 15 herrschen deutlich geringere Drücke.

Insofern ist eine geeignete Stelle zur Anordnung des thermoelektrischen Elements, welches mit der Bezugsziffer 31 versehen ist, beispielsweise innerhalb des Durchgangs 17 an der geringsten Querschnittsfläche zwischen dem Ventilglied 13 und dem Ventilsitz 15. Eine weitere geeignete Position ist die Außenfläche des kegelförmigen Ventilglieds 13, insbesondere dann, wenn ein flächenförmiges thermoelektrisches Element eingesetzt wird. Das thermoelektrische Element kann sich dann über einen breiten Bereich des Ventilglieds 13 erstrecken.

Wie in Figur 2 ersichtlich ist, ist der Durchgang 17 eher auf der stromabwärtigen Seite des Ventilglieds 13 vorgesehen, weswegen sich dort der geeignete Bereich für das thermoelektrische Element befindet. Des Weiteren kann das thermoelektrische Element innerhalb des Durchgangs 17 angeordnet sein oder auch innerhalb des stromabwärtigen Leitungsabschnitts 23 oder an dessen Innenfläche 33, wo höhere Temperaturgradienten zu erwarten sind.

Ist das thermoelektrische Element 31 an dem Ventilglied 13 angeordnet, kann eine elektrische Leitungsführung, wie ein Kabel, (nicht dargestellt) über das Ventilglied 13 und die Stellstange 5 zu einem elektrischen Verbraucher geführt werden. Ähnliches gilt für die Anordnung des thermoelektrischen Elements 31 an der Innenseite des Ventilsitzes 15, wobei die elektrische Leitung dann entsprechend durch Abschnitte des Gehäuses 3 des Stellventils 1 verlegt sein können.

Das thermoelektrische Element kann vorteilhafterweise aus vielen Einzelelementen bestehen, die vorzugsweise durch eine Dünnfilmstruktur gebildet sind und eine Stärke von wenigen Millimetern, vorzugsweise von 1 bis 2 mm, aufweisen. Als Beispiel für einen Dünnfilmgenerator ist das Produkt MPG-D651 oder MPG-D751 des Unternehmens Mikropelt GmbH zu nennen. Ein entsprechender Dünnfilmgenerator ist in einer Art Sandwichstruktur gebildet, bei der eine Wärmeplatte sowie ein Silikonsubstrat aufeinanderliegen, wobei zwischen den beiden Lagen sogenannte n-legs und p-legs angeordnet sind.

Gerade diese Dünnfilmgeneratoren sind dazu geeignet, unmittelbar an der Innen- bzw. Außenfläche des Ventilsitzes 15 oder des Stellglieds 13 angeordnet zu werden.

Es zeigte sich, dass mit den thermoelektrischen Elementen innerhalb der Prozessmediumströmungen elektrische Energie von einigen Milliwatt, insbesondere bis zu 20 mW und mehr, erreicht werden können.

Die in der vorstehenden Beschreibung, den Figuren und den Ansprüchen offenbarten Merkmale können sowohl einzeln als auch in beliebiger Kombination für die Realisierung der Erfindung in den verschiedenen Ausgestaltungen von Bedeutung sein.

### Bezugszeichenliste

- 1: Stellventil
- 3: Gehäuse
- 5: Stellstange
- 7: Öffnung
- 11: Gehäuseinneres
- 13: Ventilglied
- 15: Ventilsitz
- 17: Ventildurchgang
- 21: stromaufwärtiger Leitungsabschnitt
- 23: stromabwärtiger Leitungsabschnitt
- 31: thermoelektrisches Element
- 33: Innenfläche

- B: Kreis
- P: Strömungsdruck
- p₁. p₂: Strömungsdruck
- pₘᵢₙ: minimaler Druck

## Patentansprüche

1. Stellventil (1) zum Einstellen einer Prozessmediumsströmung einer prozesstechnischen Anlage, umfassend ein Gehäuse (3) mit einem von dem Prozessmedium zu durchströmenden Innenraum, einem im Gehäuseinnenraum (11) liegenden Ventilsitz (15), ein den Ventilsitz (15) belegendes oder freigebendes Ventilglied (13), wobei ein Durchströmungsquerschnitt des Stellventils (1) je nach relativer Position zwischen dem Ventilglied (13) und dem Ventilsitz (15) zum Einstellen der Prozessmediumsströmung veränderbar ist, um eine Druckänderung in der Prozessmediumsströmung zwischen dem stromabwärtigen und stromaufwärtigen Leitungsabschnitt (21, 23) zu veranlassen, und einen elektrischen Verbraucher, wie einen Sensor, einen Stellungsregler, einen Sender, einen Akkumulator, wobei zusätzlich ein thermoelektrisches Element (31) in dem Gehäuseinnenraum (11) angeordnet ist, das zur Versorgung mit elektrischer Energie an den elektrischen Verbraucher gekoppelt ist und am Ort der Anordnung des thermoelektrischen Elements wegen einer bei Druckdifferenz einhergehenden Temperaturdifferenz elektrische Energie zur Weiterleitung an den Verbraucher erzeugt, wobei das thermoelektrische Element an einer Außenseite des Ventilglieds (13) und/oder an einer Innenseite des Ventilsitzes (15) angeordnet ist.

2. Stellventil (1) nach Anspruch 1, **dadurch gekennzeichnet, dass** das thermoelektrisches Element (31) im Bereich eines Durchströmungsquerschnitts zwischen dem Ventilglied (13) und dem Ventilsitz (15) positioniert ist.

3. Stellventil (1) nach Anspruch 1 oder 2, **dadurch gekennzeichnet, dass** das thermoelektrische Element an einer Profilierung, wie einer Stufe, eines Absatzes, eines Hinterschnitts, des Ventilsitzes (15) und/oder des Ventilglieds (13) angeordnet ist, an der sich im Falles eines allmählichen Anstiegs des Druckabfalls des Prozessmediumsströmung zuerst überkritische Strömungsbedingungen einstellen.

4. Stellventil (1) nach einem der vorstehenden Ansprüche, **dadurch gekennzeichnet, dass** das thermoelektrische Element innerhalb eines Strömungsdurchgangs zwischen dem Ventilglied (13) und dem Ventilsitz (15) im Abstand davon angeordnet ist, wobei der Anordnungspunkt des thermoelektrischen Elements in dem Durchgang strömungsabwärts des Ventilsitzes (15) und/oder des Ventilglieds (13) positioniert ist.

5. Stellventil (1) nach einem der vorstehenden Ansprüche, **dadurch gekennzeichnet, dass** das Gehäuse (3) einen stromabwärtigen Leitungsabschnitt (23) und einen stromaufwärtigen Leitungsabschnitt (21) aufweist, wobei der Ventilsitz (15) den stromabwärtigen Leitungsabschnitt (23) von dem stromaufwärtigen Leitungsabschnitt (21) trennt, wobei das thermoelektrische Element im Inneren des stromabwärtigen Leitungsabschnitts (23) in einem Abstand von einer Leitungswand und/oder an einer Innenseite der Leitungswand positioniert ist.

6. Stellventil (1) nach einem der vorstehenden Ansprüche, **dadurch gekennzeichnet, dass** das thermoelektrisches Element (31) im Bereich von oder auf einer dem Ventilsitz (15) zugewandten Außenfläche des Ventilglieds (13) positioniert ist, die auf einer dem stromabwärtigen Leitungsabschnitt (23) zugewandten Seitenhälfte liegt, im Falle eines rotationsförmigen, zylindrischen und/oder kegelförmigen Ventilglieds (13), auf einer dem stromabwärtigen Leitungsabschnitt (23) nächst liegenden Tangentiallinie positioniert ist.

7. Stellventil (1) nach einem der vorstehenden Ansprüche, **dadurch gekennzeichnet, dass** das thermoelektrische Element an einer dem Ventilglied (13) zugewandten Innenseite des Ventilsitzes (15) positioniert ist, die auf einer dem stromabwärtigen Leitungsabschnitt (23) naheliegenden Seitenhälfte liegt, im Falle eines kreisringförmigen Ventilsitzes (15) in einem Bereich liegt, der dem stromaufwärtigen Leitungsabschnitt (21) zugewandt ist.

8. Stellventil (1) nach einem der vorstehenden Ansprüche, **dadurch gekennzeichnet, dass** das thermoelektrische Element eine dünne Plattenstruktur bildet, die derart angeordnet ist, dass sich zumindest ein Teil der Plattenstruktur in einem Bereich des größten Druckabfalls der Prozessmediumsströmung längs des Strömungsverlaufs erstreckt.

9. Stellventil (1) nach Anspruch 8, **dadurch gekennzeichnet, dass** die Plattenstruktur des thermoelektrischen Elements eine Silikon-Wafer-Struktur bildet, wobei der Wafer ventilsitzseitig und/oder ventilgliedseitig angeordnet ist, während eine Silikonschicht prozessmediumsströmungsseitig positioniert ist, wobei zwischen dem Wafer und der Silikonschicht eine Vielzahl von thermoelektrischen Verbundstoffpaaren in einer Sandwichanordnung eingebracht sind.

10. Verfahren zum Bereitstellen elektrischer Energie für einen elektrischen Verbraucher eines Stellventils (1) zum Einstellen einer Prozessmediumströmung, umfassend ein Gehäuse (3) mit einem von dem Prozessmedium zu durchströmenden Innenraum, einem im Gehäuseinnenraum (11) liegenden Ventilsitz (15), ein den Ventilsitz (15) belegendes oder freigebendes Ventilglied (13), wobei in einem Leitungssystem für die Prozessmediumströmung wenigstens eine gegebenenfalls veränderbare Querschnittsverengung vorgesehen wird oder ist, wie eine fest montierte Blende oder eine Drosselstelle eines Prozessventils, wobei an der Querschnittsverengung ein thermoelektrische Element an einer Außenseite des Ventilglieds (13) und/oder an einer Innenseite des Ventilsitzes (15) angeordnet wird, das zur Versorgung elektrischer Energie mit dem elektrischen Verbraucher gekoppelt wird und am Ort der Anordnung des thermoelektrischen Elements mittels einer mit dem Druckabfall einhergehenden Temperaturdifferenz elektrische Energie zur Weiterleitung an den elektrischen Verbraucher durch das thermoelektrische Element erzeugt wird.

11. Verfahren nach Anspruch 10, **dadurch gekennzeichnet, dass** es gemäß der Funktionsweise eines nach einem der Ansprüche 1 bis 9 ausgebildeten Stellventils (1) verfährt.

## Claims

1. Control valve (1) for adjusting a process medium flow of a technical process installation, comprising a housing (3) with an interior to be traversed by the process medium, a valve seat (15) disposed inside the housing interior (11), a valve member (13) obstructing or clearing the valve seat (15), wherein a flow cross section of the control valve (1) can be altered according to the relative position between the valve member (13) and the valve seat (15) for adjusting the process medium flow in order to initiate a pressure change in the process medium flow between the upstream and the downstream duct section (21, 23), and an electrical consumer like a sensor, a positioner, a sender, an accumulator, wherein additionally a thermoelectric element (31) is disposed in the housing interior (11) which thermoelectric element (31) is coupled to the electrical consumer for supplying electric power and generates electric power, to be conducted to the consumer, at the location of the disposal of the thermoelectric element owing to a temperature difference that accompanies pressure difference, wherein the thermoelectric element is disposed at an outside of the valve member (13) and/or at an inside of the valve seat (15).

2. Control valve (1) according to claim 1, **characterised in that** the thermoelectric element (31) is positioned in the area of a flow cross section between the valve member (13) and the valve seat (15).

3. Control valve (1) according to claim 1 or 2, **characterised in that** the thermoelectric element is disposed at a profiling like a step, an offset, an undercut of the valve seat (15) and/or of the valve member (13), at which profiling supercritical flow conditions will arise first in case of a gradual increase of the pressure drop of the process medium flow.

4. Control valve (1) according to one of the preceding claims, **characterised in that** the thermoelectric element is positioned within a flow passage between the valve member (13) and the valve seat (15) at a distance to the latter, wherein the point of disposal of the thermoelectric element is positioned in the passage downstream of the valve seat (15) and/or of the valve member (13).

5. Control valve (1) according to one of the preceding claims, **characterised in that** the housing (3) has a downstream duct section (23) and an upstream duct section (21), wherein the valve seat (15) separates the downstream duct section (23) from the upstream duct section (21), wherein the thermoelectric element is positioned inside the downstream duct section (23) at a distance to a duct wall and/or at an inner side of the duct wall.

6. Control valve (1) according to one of the preceding claims, **characterised in that** the thermoelectric element (31) is positioned at or in the area of an outer surface of the valve member (13) facing the valve seat (15), which outer surface is disposed at a lateral half facing the downstream duct section (23), in case of a rotosymmetrical, cylindrical and/or cone-shaped valve member (13), at a tangential line closest to the downstream duct section (23).

7. Control valve (1) according to one of the preceding claims, **characterised in that** the thermoelectric element is positioned at an inner side of the valve seat (15) facing the valve member (13), which inner side is disposed at a lateral half close to the downstream duct section (23), in case of a circular shaped valve seat (15), is disposed in an area facing the upstream duct section (21).

8. Control valve (1) according to one of the preceding claims, **characterised in that** the thermoelectric element forms a thin plate structure that is disposed such that at least a portion of the plate structure extends into an area of the largest pressure drop of the process medium flow along the course of the flow.

9. Control valve (1) according to claim 8, **characterised in that** the plate structure of the thermoelectric element forms a silicon wafer structure, wherein the wafer is disposed at the side of the valve seat and/or at the side of the valve member while a silicon layer is positioned at the side of the process medium flow, wherein a multitude of thermoelectric pairs of compound material are introduced inbetween the wafer and the silicon layer in a sandwich arrangement.

10. Method for providing electric power for an electrical consumer of a control valve (1) for adjusting a process medium flow, comprising a housing (3) with an interior to be traversed by the process medium, a valve seat (15) disposed inside the housing interior (11), a valve member (13) obstructing or clearing the valve seat (15), wherein, in a duct system for the process medium flow, at least one cross section restriction, which can be altered if required, is/comes to be provided, like a fixed baffle or a throttling point of a process valve, wherein a thermoelectric element is disposed at the cross section restriction at an outside of the valve member (13) and/or at an inside of the valve seat (15), which element is being coupled to the electric consumer for supplying electric power, and electric power, to be conducted to the electrical consumer, is generated by the thermoelectric element at the location of the disposal of the thermoelectric element by means of a temperature difference that accompanies pressure difference.

11. Method according to claim 10, **characterised in that** it operates according to the functionality of a control valve (1) formed according to one of the claims 1 to 9.

## Revendications

1. Soupape de régulation (1) destinée à régler un courant de fluide de procédé d'une installation technique de processus, comprenant un corps (3) doté d'un espace intérieur qui doit être traversé par le fluide de processus, un siège de soupape (15) situé l'intérieur du corps (11), un organe de soupape (13) occupant ou libérant le siège de soupape (15), en fonction de la position relative entre l'organe de soupape (13) et le siège de soupape (15), une section transversale de circulation de la soupape de régulation (1) étant variable pour le réglage du courant de fluide de procédé, pour initier une modification de pression dans le courant de fluide de procédé entre le tronçon de conduit (21, 23) côté aval et coté amont et un consommateur électrique, tel qu'un capteur, un positionneur, un émetteur, un accumulateur, en supplément un élément thermoélectrique (31) qui pour l'alimentation en énergie électrique est connecté sur le consommateur électrique étant placé à l'intérieur du corps (11) et à l'endroit du placement de l'élément thermoélectrique, suite à une température différentielle accompagnant une pression différentielle, générant de l'énergie électrique qui doit être retransmise au consommateur, l'élément thermoélectrique étant placé sur une face extérieure de l'organe de soupape (13) et/ou sur une face intérieure du siège de soupape (15).

2. Soupape de régulation (1) selon la revendication 1, **caractérisée en ce que** l'élément thermoélectrique (31) est positionné dans la région d'une section transversale de circulation entre l'organe de soupape (13) et le siège de soupape (15).

3. Soupape de régulation (1) selon la revendication 1 ou 2, **caractérisée en ce que** l'élément thermoélectrique est placé sur un profilage, tel qu'un échelon, un talon, une contre-dépouille du siège de soupape (15) et/ou de l'organe de soupape (13) sur lequel, dans le cas d'un éventuel accroissement de la chute de pression du courant de fluide de processus s'installent en premier lieu des conditions d'écoulement surcritiques.

4. Soupape de régulation (1) selon l'une quelconque des revendications précédentes, **caractérisée en ce que** l'élément thermoélectrique est placé à l'intérieur d'un passage d'écoulement entre l'organe de soupape (13) et le siège de soupape (15), avec un écart par rapport à celui-ci, le point de placement de l'élément thermoélectrique dans le passage étant positionné en aval du siège de soupape (15) et/ou de l'organe de soupape (13).

5. Soupape de régulation (1) selon l'une quelconque des revendications précédentes, **caractérisée en ce que** le corps (3) comporte un tronçon de conduit (23) en aval et un tronçon de conduit (21) en amont, le siège de soupape (15) séparant le tronçon de conduit (23) en aval du tronçon de conduit (21) en amont, l'élément thermoélectrique étant positionné à l'intérieur du tronçon de conduit (23) en aval, avec un écart par rapport à une paroi de conduit et/ou à une face intérieure du paroi de conduit.

6. Soupape de régulation (1) selon l'une quelconque des revendications précédentes, **caractérisée en ce que** l'élément thermoélectrique (31) étant positionné dans la région dans ou sur une surface extérieure de l'organe de soupape (13) qui fait face au siège de soupape (15), qui se situe sur une moitié de côté qui fait face au tronçon de conduit (23) côté aval, dans le cas d'un organe de soupape (13) conformé en rotation, cylindrique et/ou cunéiforme, étant positionné sur une ligne tangentielle la plus proche du tronçon de conduit (23) en aval.

7. Soupape de régulation (1) selon l'une quelconque des revendications précédentes, **caractérisée en ce que** l'élément thermoélectrique est positionné sur une face intérieure du siège de soupape (15) dirigée vers l'organe de soupape (13) qui se situe sur une moitié de côté dirigée vers le tronçon de conduit (23) côté aval, qui dans le cas d'un siège de soupape (15) en forme d'anneau circulaire, se situe dans une région qui est dirigée vers le tronçon de conduit (21) côté amont.

8. Soupape de régulation (1) selon l'une quelconque des revendications précédentes, **caractérisée en ce que** l'élément thermoélectrique forme une structure en plaque mince qui est placée de sorte à ce qu'au moins une partie de la structure en plaque s'étende dans une région de la chute de pression la plus importante du courant de fluide de procédé, le long du trajet d'écoulement.

9. Soupape de régulation (1) selon la revendication 8, **caractérisée en ce que** la structure en plaque de l'élément thermoélectrique forme une structure en tranche de silicone, la tranche étant placée du côté siège de soupape et/ou du côté organe de soupape, alors qu'une couche de silicone est placée du côté écoulement du fluide de processus, entre la tranche et la couche de silicone, une pluralité de paires de matière composite thermoélectrique étant introduites dans un placement en sandwich.

10. Procédé, destiné à mettre à disposition de l'énergie électrique pour un consommateur électrique d'une soupape de régulation (1) destinée à régler un courant de fluide de procédé d'une installation technique de processus, comprenant un corps (3) doté d'un espace intérieur qui doit être traversé par le fluide de processus, un siège de soupape (15) situé l'intérieur du corps (11), un organe de soupape (13) occupant ou libérant le siège de soupape (15), lors duquel, dans un système de conduit destiné au courant de fluide de processus, on prévoit ou est prévu un rétrécissement de section transversale variable le cas échéant, comme un cache monté de manière fixe ou une zone d'étranglement d'une soupape de processus, lors duquel, sur le rétrécissement de section transversale, on place sur une face extérieure de l'organe de soupape (13) et/ou sur une face intérieure du siège de soupape (15) un élément thermoélectrique qui pour l'alimentation en énergie électrique est connecté sur le consommateur électrique et à l'endroit du placement de l'élément thermoélectrique, au moyen d'une température différentielle accompagnant une chute de pression, de l'énergie électrique destinée à être retransmise au consommateur électrique est générée par l'élément thermoélectrique.

11. Procédé selon la revendication 10, **caractérisé en ce qu'**il procède selon le monde de fonctionnement d'une soupape de régulation (1) conçue selon l'une quelconque des revendications 1 à 9.
